# EUROPÄISCHE PATENTSCHRIFT

(11) **EP 2 220 919 B1**
(45) Veröffentlichungstag und Bekanntmachung des Hinweises auf die Patenterteilung: **28.12.2011**
(21) Anmeldenummer: 08805254.3
(22) Anmeldetag: 13.10.2008
(51) Int. Cl.: H05K 3/40

(54) **VERFAHREN ZUR HERSTELLUNG EINER LEITERPLATTENSCHICHT (SCHALTUNGSEBENE) FÜR EINE INSBESONDERE MEHRSCHICHTIGE LEITERPLATTE (KERAMISCHES SUBSTRAT)**
METHOD FOR THE PRODUCTION OF A CIRCUIT BOARD LAYER (CIRCUIT PLANE) FOR A PARTICULARLY MULTI-LAYER CIRCUIT BOARD (CERAMIC SUBSTRATE)
PROCÉDÉ DE FABRICATION D'UNE COUCHE DE CARTE DE CIRCUIT (PLAN DE CIRCUIT) POUR UNE CARTE DE CIRCUIT EN PARTICULIER MULTICOUCHE (SUBSTRAT CÉRAMIQUE)

(30) Priorität: 03.12.2007 DE 102007058094
(43) Veröffentlichungstag der Anmeldung: 25.08.2010
(73) Patentinhaber: Robert Bosch GmbH, 70442 Stuttgart (DE)
(72) Erfinder: TAUBER, Peter, 72074 Tuebingen (DE); SENTUERK, Tuncay, 72762 Reutlingen (DE); SPEH, Ulrich, 71144 Steinenbronn (DE)
(86) Internationale Anmeldenummer: PCT/EP2008/063724
(87) Internationale Veröffentlichungsnummer: WO 2009/071363

(56) Entgegenhaltungen:
- GB-A- 2 262 661
- US-A- 3 956 052
- ANONYMOUS: "Via Processing Technique for Decal Transfer Technology" IBM TECHNICAL DISCLOSURE BULLETIN, Bd. 32, Nr. 2, 1. Juli 1989 (1989-07-01), Seiten 475-476, XP002508507 New York, US

## Beschreibung

Die Erfindung betrifft ein Verfahren zur Herstellung einer Leiterplattenschicht (Schaltungsebene) für eine insbesondere mehrschichtige Leiterplatte, wobei eine Keramikfolie mit darauf angeordneter Trägerfolie verwendet wird.

### Stand der Technik

Die ständig fortschreitende Miniaturisierung und stetig komplexer werdende elektronische Schaltungen erfordern Herstellung und Einsatz von Multilayerschaltungen, also solchen Schaltungen, bei denen Schaltungsbausteine in mehreren Ebenen angeordnet und zu einer funktionalen Einheit verbunden sind. Im Stand der Technik sind hierfür keramische Multilayerschaltungen bekannt, die aus flexiblen keramischen, sogenannten Grünfolien hergestellt werden, die aus organischen Bindern, Lösemitteln und anorganischen Bestandteilen bestehen. Im heutigen Prozessfluss zur Herstellung der Multilayerschaltung in Multilayerkeramik-Bauweise lassen sich grob zwei Prozessabschnitte unterscheiden, nämlich der Cofire- und der Postfire-Prozess, wobei der Cofire-Prozess die Bearbeitung im Grünzustand und der Postfire-Prozess die Bearbeitung im Keramikzustand umschreibt. Im ersten Prozessabschnitt, dem Cofire-Prozess, ist der im Stand der Technik geläufige Prozessablauf dergestalt, dass die keramischen Grünfolien auf einem Trägermedium aufgebracht sind und durch Stanzen der Grünfolien, also einem mechanischen Bearbeitungsschritt, eine Strukturierung der Schaltung in Abhängigkeit von der Ausgestaltung der Schaltung für das Produkt, in dem sie verwendet werden soll, erfolgt. Hierbei werden insbesondere die einzelnen Schaltungswege, also beispielsweise Leiterbahnen, angelegt. Sodann werden Durchkontaktierungen, sogenannte Vias, mittels einer dieser Vias repräsentierenden Schablone beziehungsweise mittels eines solchen Siebes gedruckt, was bedeutet, dass die als Vias gestanzten Löcher mit elektrisch leitender Dickschichtpaste mittels eines Siebdruckverfahrens gefüllt werden. Sodann wird die mit den Vias bedruckte Grünfolie getrocknet. Anschließend werden mittels einer weiteren, anderen Schablone Leiterbahnen auf die Gründfolie aufgedruckt; die hier verwendete Schablone gibt das Druckbild der Leiterbahnen wieder. Anschließend wird die nunmehr mit Vias und mit Leiterbahnen bedruckte Grünfolie erneut getrocknet. Im nächsten Verarbeitungsschritt werden mehrere solcher Art hergestellten Grünfolien gestapelt und laminiert, wodurch sich das Laminat der Multilayerschaltung ergibt. Anschließend werden die Grünfolien beziehungsweise das Laminat insgesamt gesintert, wodurch sich die keramische Multilayerschaltung ergibt. Es ist hierbei eine Vielzahl von Prozessschritten erforderlich, die insbesondere in hohem Maße anfällig gegen Maßabweichungen und Lageabweichungen zwischen einzelnen Verfahrensschritten sind, beispielsweise der Druckprozesse hinsichtlich der Durchkontaktierungen (Vias) und der Leiterbahnen, wobei extrem hohen Maßhaltigkeitsanforderungen genügt werden muss. Hieran ist weiter nachteilig, dass eine Mehrzahl unterschiedlich ausgestalteter beziehungsweise bestückter Maschinen für verschiedene Bearbeitungsschritte in der Serienfertigung verwendet werden muss, überdies ist eine hohe Belegung von Pufferplätzen für beispielsweise Trocknungs- und Zwischenlagerzeiten nachteilig. Weiter ist nachteilig, dass insbesondere nach den Stanz- und Druckprozessen jeweils eine Qualitätskontrolle stattfinden muss, um die geforderten Maßhaltigkeiten einhalten zu können. Durch die im Stand der Technik bekannte Verfahrenstechnik sind die Leiterbahnabstände und
Via-Durchmesser nicht beliebig miniaturisierbar; es bestehen zur Zeit Limitierungen hinsichtlich dieser Miniaturisierung von etwa 80 µm für Via-Durchmesser und hinsichtlich der Leiterbahnbreite von etwa 130 um. Hierdurch wird eine noch kompaktere Ausgestaltung der Multilayerschaltungen verhindert.

US3956052 offenbart ein Verfahren zur Herstellung einer Leiterplattenschicht wobei eine Keramikfolie mit darauf angeordneter Trägerfolie durch Lasern gelocht wird, anschließend Leiterbahnen und Durchkontaktierungen erstellt werden und danach die Trägerfolie von der Keramikfolie entfernt wird.

### Offenbarung der Erfindung

Aufgabe der Erfindung ist es, ein Verfahren zur Herstellung keramischer Multilayerschaltungen bereitzustellen, das die genannten Nachteile vermeidet, und vorteilhaft bei sehr hoher Präzision die effektive und kostengünstige Herstellung von Leiterplattenschichten, nämlich keramischen Schaltungsebenen, der gattungsgemäßen Art ermöglicht.

Hierzu wird ein Verfahren zur Herstellung einer Leiterplattenschicht für eine insbesondere mehrschichtige Leiterplatte vorgeschlagen, wobei eine Keramikfolie mit darauf angeordneter Trägerfolie verwendet wird, die Trägerfolie zur Ausbildung mindestens einer Leiterbahn durch Lasern gelocht und/oder die Trägerfolie und die Keramikfolie zur Ausbildung mindestens einer Durchkontaktierung gemeinsam durch Lasern gelocht werden, anschließend durch Bedrucken die Leiterbahn und/oder die Durchkontaktierung erstellt werden, wobei die Trägerfolie eine Druckschablone bildet, und anschließend die Trägerfolie von der Keramikfolie entfernt wird. Unter Keramikfolie wird hier beispielsweise eine aus dem Stand der Technik bekannte, keramische Grünfolie verstanden. Diese weist ein Trägermedium auf, nämlich die Trägerfolie. Dieses wird durch Beaufschlagung mit einem Laser gelocht oder es werden Trägerfolie und Keramikfolie zur Ausbildung von Durchkontaktierungen gemeinsam durch den Laser gelocht. Dieser Verfahrensschritt ersetzt die Stanzungen in den im Stand der Technik bekannten Verfahren. Anschließend werden die Leiterbahn und/oder die Durchkontaktierung erstellt, nämlich durch Bedrucken mit elektrisch leitender Dickschichtpaste. Diese ist hinsichtlich ihrer rheologischen Eigenschaften dahingehend auszuwählen oder zu formulieren, dass sie sowohl den Anforderungen für das Füllen der Vias (Durchkontaktierungen) als auch denen des flächigen Leiterbahnendrucks genügen muss. Überdies muss sie spezielle Sintereigenschaften entsprechend der im Stand der Technik bekannten Paste für Durchkontaktierungen aufweisen. Beim Bedrucken der Leiterbahnen und/oder Durchkontaktierungen, die auf diese Weise erstellt werden, dient die Trägerfolie als Druckschablone. Anders als im Stand der Technik wird nicht eine vom Schaltungslayout abhängige, separate Schablone mit entsprechenden Maßhaltigkeits- und Passgenauigkeitsanforderungen auf die Keramikfolie aufgelegt und diese als Druckschablone für das Bedrucken verwendet, sondern die Trägerfolie selbst, die durch das Lasern Ausnehmungen bis auf die Keramikfolie oder Ausnehmungen durch die Keramikfolie hindurch aufweist, dient in ihrem auf die Keramikfolie aufgebrachten, fixierten Zustand als Druckschablone. Die Druckschablone wird hierbei gewissermaßen durch das Lasern selbst hergestellt, die Druckschablone ist gewissermaßen eine Einmal-Druckschablone, die nur für das Bedrucken genau der Keramikfolie Anwendung findet, auf der sie ursprünglich auch aufgebracht war. Hierdurch entfallen sämtliche Toleranz-, Maßhaltigkeits- und Passgenauigkeitsprobleme, die aus dem Stand der Technik bekannt sind. Insbesondere ist es hierbei auch möglich, einen höheren Grad an Miniaturisierung hinsichtlich der Durchkontaktierungen und der Leiterbahnen zu erreichen. Es wird zusätzlich lediglich noch eine Art Universalschablone benötigt, die aber ausschließlich dem Transport der Paste dient. Sie weist ihrerseits keine Strukturen entsprechend des Schaltungslayouts auf. Nach dem Bedrucken wird die Trägerfolie entfernt, wodurch sich die Leiterplattenschicht (Schaltungsebene) im Fertigstellungsstadium am Ende des Cofire-Prozesses und bereit zum Laminieren mit anderen Leiterplattenschichten ergibt.

In einer weiteren Verfahrens schritt der Erfindung wird das Entfernen der Trägerfolie mittels eines auf die Trägerfolie aufgeklebten Klebsubstrat, insbesondere Trägerfolie, bewirkt, die gemeinsam mit der Trägerfolie anschließend wieder abgezogen wird. Im Stand der Technik ist es üblich, die Trägerfolie vor dem Stapeln/Laminieren mit einem Angriff an einer Ecke derselben seitlich abzuziehen. Dies ist bei laserstrukturierter Trägerfolie der erfindungsgemäßen Art nicht möglich, weshalb auf die laserstrukturierte Trägerfolie, die die Ausnehmungen durch Lasern aufweist, eine zweite Klebefolie oder ein anderes, geeignetes Trägersubstrat aufgeklebt und anschließend mit der Trägerfolie wieder abgezogen wird. Die laserstrukturierte/gelochte Trägerfolie bleibt demzufolge an der Klebefolie haften und wird mit dieser von der bedruckten Keramikfolie entfernt. Als Klebefolie kommt insbesondere eine weitere Trägerfolie, wie aus dem Stand der Technik bekannt, in Betracht. Diese haben übrigens den Vorteil, in großen Mengen im Herstellungswerk verfügbar zu sein.

In einer weiteren Verfahrensausbildung wird die Leiterplattenschicht mindestens mit einer weiteren Leiterplattenschicht verbunden. Mehrere Leiterplattenschichten werden demzufolge zu einer Multilayerschaltung gestapelt und laminiert.

Letztendlich wird die aus mehreren Leiterplattenschichten bestehende Leiterplatte, nämlich die Multilayerschaltung, gesintert, hiermit dem letzten Verfahrensschritt des Cofire-Prozesses zugeführt. Beim Sintern verfestigen sich die bisherigen Keramikfolien und Leiterbahnen sowie Durchkontaktierungen zu der Multilayerschaltung.

Vorteile der erfindungsgemäßen Verfahrens liegen insbesondere darin, dass keine layout- und ebenenabhängigen Werkzeuge für das Stanzen, wie im Stand der Technik erforderlich, benötigt werden, da ein einziger Laser, beispielsweise ein CO₂-Laser, alle Verfahrensschritte, in denen Lochungen von Trägerfolie und/oder Keramikfolie hergestellt werden, ausführen kann; der Laser wird hierbei lediglich in seiner Leistung entsprechend der Einbrenntiefe variiert, er wird also für das Herstellen der Durchkontaktierungen (Vias) stärker, nämlich mit einer höheren Leistung, eingestellt werden oder die entsprechende Stelle länger beaufschlagen als beim Herstellen von Leiterbahnen. Anders als im Stand der Technik erfolgt die Bedruckung im Simultandruckverfahren, das heißt, Durchkontaktierungen und Leiterbahnen werden in einem Arbeitsgang hergestellt. Auch hier sind keine layout- und ebenenabhängigen Werkzeuge für das Drucken der Durchkontaktierungen und/oder Leiterbahnen erforderlich. Weiter sind keine separaten Drucker zur Bedruckung der Durchkontaktierungen und Leiterbahnen erforderlich, da die Bedruckung von einer einzigen Maschine durchführbar ist. Durch eine weitgehend werkzeuglose Fertigung und die Einsparung der Belegung von Pufferplätzen beispielsweise durch Entfall der Trocknungsschritte nach dem Druck der Durchkontaktierungen sowie der Verwendung nur einer Paste für Durchkontaktierungen und Leiterbahnen ergibt sich eine erhebliche Einsparung an Reinraumfläche, Lagerplätzen und Verbrauchsstoffen. Der Entfall von separatem Druck, von Rüstzeiten für jede Ebene und für jedes Layout beim Herstellen der im Stand der Technik üblichen Stanzungen, beim Drucken der Durchkontaktierungen und beim Leiterbahndruck reduziert die Durchlaufzeiten und die Anzahl der Prozesse; weiter wird die Prozesskontrolle, insbesondere die Qualitätskontrolle, erheblich vereinfacht und verschlankt.

Weitere vorteilhafte Ausführungsformen ergeben sich aus den Unteransprüchen und aus Kombinationen derselben.

### Kurze Beschreibung der Zeichnungen

Das Verfahren wird nachfolgend anhand einzelner Verfahrensschritte näher erläutert.

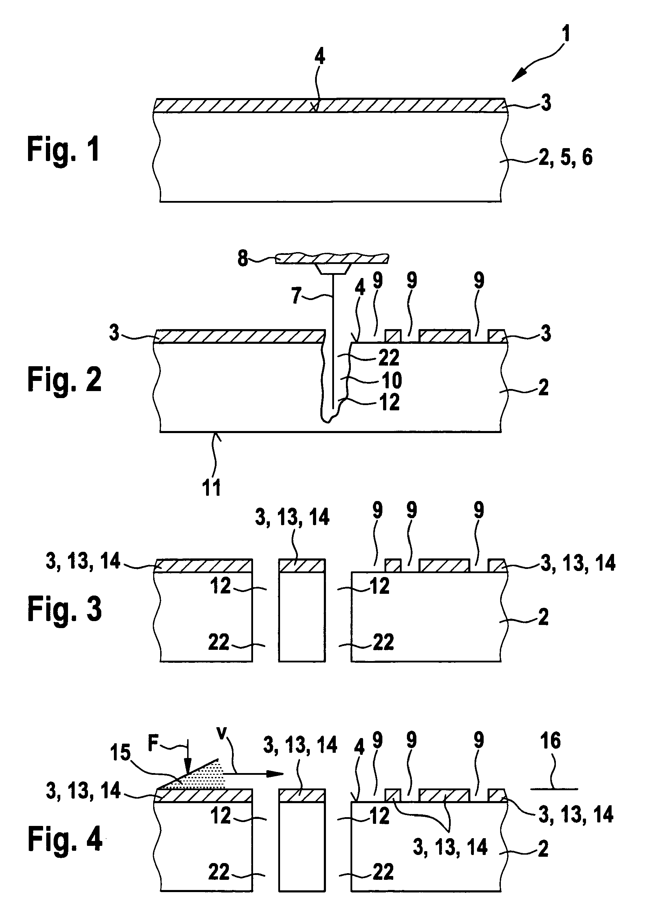

Es zeigen
- Figuren 1 bis 7: einzelne Verfahrensschritte der Herstellung einer Leiterplattenschicht (Schaltungsebene) für eine insbesondere mehrschichtige Leiterplatte (keramisches Substrat).

### Ausführungsform(en) der Erfindung

Figur 1 zeigt Rohmaterial 1 zur Herstellung einer Leiterplattenschicht, nämlich eine Keramikfolie 2 mit einer auf dieser angebrachten Trägerfolie 3. Die Trägerfolie ist vollflächig mit einer Oberseite 4 der Keramikfolie 2 verklebt. Die Keramikfolie 2 ist eine Grünfolie 5, insbesondere eine flexible keramische Grünfolie 6.

Figur 2 zeigt die Beaufschlagung des Rohmaterials 1 mit einem Laserstrahl 7, der mittels einer Lasereinrichtung 8 über das Rohmaterial 1 in Abhängigkeit vom gewünschten Layout der herzustellenden Leiterplattenschicht geführt wird. Der Laserstrahl 7 locht durch Energiebeaufschlagung in Lochungsbereichen 9 die Trägerfolie 3, so dass diese bis zu der Oberseite 4 der Keramikfolie 2 entfernt wird. Die Oberseite 4 der Keramikfolie 2 liegt demzufolge im Anschluss an diese Lochung durch den Laserstrahl 7 frei. Der Laserstrahl 7 kann weiter beispielsweise durch Erhöhung seiner Laserleistung zum Lochen der Keramikfolie 2, nämlich zum Herstellen von Vias 22 für Durchkontaktierungen 10, eingestellt werden; in diesem Fall ist die Laserleistung so bemessen oder die Verweildauer des Laserstrahls 7 so eingestellt, dass nicht nur die Trägerfolie 3 gelocht wird, sondern auch die Keramikfolie 2. Die Lochung der Keramikfolie 2 zur Herstellung der Durchkontaktierung 10 wird solange fortgesetzt, bis die Keramikfolie 2 an der Stelle, an der die Durchkontaktierung 10 entstehen soll, vollständig gelocht ist, also von der Oberseite 4 bis hin zur Unterseite 11, und so eine durchgehende Durchkontaktierungslochung 12, nämlich das Via 22, entsteht.

Figur 3 zeigt die Keramikfolie 3 nach Herstellung von Durchkontaktierungslochungen 12 (Vias 22) und Lochungsbereichen 9 und aufliegender Trägerfolie 3. Die Trägerfolie 3 ist sowohl in den Lochungsbereichen 9 als insbesondere auch in den Durchkontaktierungslochungen 12 entfernt; zusätzlich sind in den Durchkontaktierungslochungen 12 sämtliche dort ursprünglich befindlichen Materialbestandteile der Keramikfolie 2 ebenfalls entfernt; die Durchkontaktierungslochungen 12 durchdringen folglich die Keramikfolie 2 und die Trägerfolie 3 unter Ausbildung der Vias 22 vollständig. Die Trägerfolie 3 bildet mit ihren verbliebenen Trägerfolienbestandteilen 13 eine Druckschablone 14 aus. Sie überdeckt nämlich Bereiche der Oberseite 4 der Keramikfolie 2, die nicht bedruckt werden sollen, und gibt die Lochungsbereiche 9 sowie die Durchkontaktierungslochungen 12 zur Bedruckung frei. Der Einsatz einer separaten Druckschablone, die passgenau an das gewünschte Layout der herzustellenden Leiterplattenschicht angepasst aufgebracht werden muss, erübrigt sich hierbei.

Figur 4 zeigt das Aufbringen von elektrisch leitfähiger Druckpaste 15 auf die aus Trägerfolienbestandteilen 13 gebildete Druckschablone 14 zur Herstellung der gedruckten Schaltung auf der Keramikfolie 2 entsprechend ihrem Layout. Die Druckpaste wird hierbei unter Beaufschlagung mit einer Aufbringkraft F im Wesentlichen in einer Ebene 16 parallel zur Oberseite 4 der Keramikfolie 2 mit einer Druckgeschwindigkeit v auf die Druckschablone 14 aufgetragen. Die Druckpaste 15 ist hierbei hinsichtlich ihrer rheologischen Eigenschaften so ausgewählt oder eingestellt, dass sie sowohl die Durchkontaktierungslochungen 12 (Vias 22) als auch die Lochungsbereiche 9 im Zuge des Druckvorgangs vollständig und gleichmäßig ausfüllen kann.

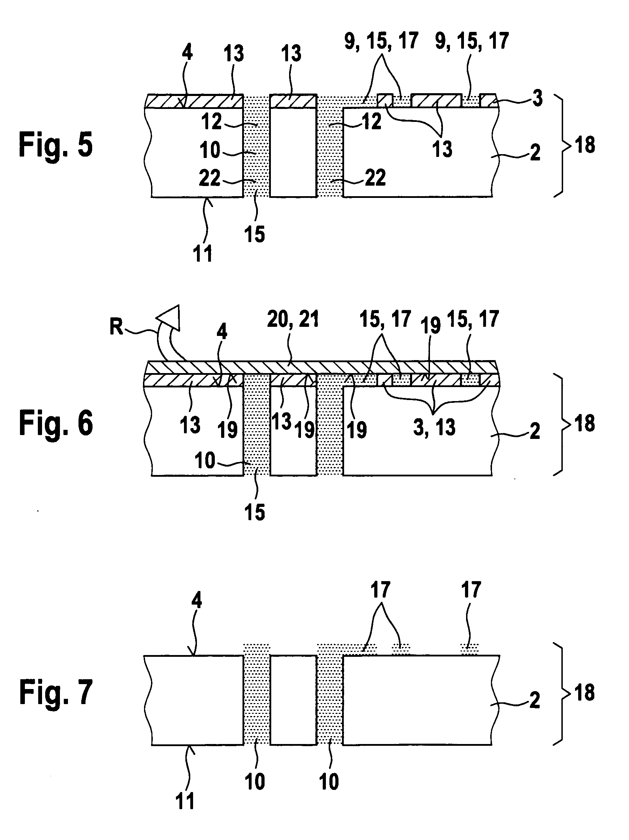

Figur 5 zeigt die Keramikfolie 2 nach dem Bedrucken. Die nicht von Trägerfolienbestandteilen 13 bedeckten Bereiche der Oberseite 4 der Trägerfolie 2 und die Durchkontaktierungslochungen 12 (Vias 22) sind hierbei mit Druckpaste 15 ausgefüllt. Die Druckpaste 15 bildet hierbei die Durchkontaktierungen 10 im Bereich der Durchkontaktierungslochungen 12 aus, nämlich die Verbindung von Oberseite 4 und Unterseite 11 der Keramikfolie 2. In den Lochungsbereichen 9, also dort, wo lediglich die Trägerfolie 3 gelocht wurde, nicht jedoch die Keramikfolie 2, ist die Druckpaste 15 zwischen den stehen gebliebenen Trägerfolienbestandteilen 13 auf der Oberseite 4 der Keramikfolie 2 eingebracht. Auf diese Weise bilden sich Leiterbahnen 17 auf der Oberseite 4 der Keramikfolie 2 und zwischen den Trägerfolienbestandteilen 13 aus. Leiterbahnen 17 und Durchkontaktierungen 10 sind auf der Keramikfolie 2 zueinander zum Layout der gewünschten Leiterbahn bedarfsweise verbunden und ergeben zusammen eine Leiterplattenschicht 18.

Figur 6 zeigt die so gewonnene Leiterplattenschicht 18 mit darauf verbliebenen, zu entfernenden Trägerfolienbestandteilen 13. Zur Entfernung dieser Trägerfolienbestandteile 13 wird auf die Leiterplattenschicht 18, nämlich auf eine Trägerfolienoberseite 19, ein Klebsubstrat 20 aufgebracht, dass mit den Trägerfolienbestandteilen 13 verklebt. Als Klebsubstrat 20 kommt insbesondere eine Klebefolie 21, beispielsweise auch in Form einer aus vorigen Prozessschritten bekannten Trägerfolie 3 in Betracht. Nach dem Verkleben des Klebsubstrats 20 mit den Trägerfolienbestandteilen 13, wodurch sich eine möglichst innige Verbindung des Klebsubstrats 20 mit den Trägerfolienbestandteilen 13 ergibt, wird das Klebsubstrat 20, beispielsweise in Richtung des Pfeils R von der Leiterplattenschicht 18 abgezogen. Die an dem Klebsubstrat 20 haftenden Trägerfolienbestandteile 13 werden hierbei ebenfalls von der Oberseite 4 der Keramikfolie 2 und von den Durchkontaktierungen 10 sowie den Leiterbahnen 17 abgezogen. Auf diese Weise lassen sich die in der Weiterverarbeitung der Leiterplattenschicht 18 unerwünschten Trägerfolienbestandteile 13 in einem Arbeitsgang vollständig von der Leiterplattenschicht 18 entfernen.

Figur 7 zeigt die so erhaltene Leiterplattenschicht 18 im Zustand nach Entfernen der Trägerfolienbestandteile 13. Es verbleibt hierbei die Keramikfolie 2, die mit Durchkontaktierungen 10 zwischen Oberseite 4 und Unterseite 11 versehen ist und die die Leiterbahnen 17 aufweist.

Die so erhaltene Leiterplattenschicht 18 kann in folgenden Verfahrensschritten mit weiteren Leiterplattenschichten 18, insbesondere mit solchen von anderem Layout, laminiert und dann durch Sintern zu einer keramischen Multilayerschaltung verbunden werden.

## Patentansprüche

1. Verfahren zur Herstellung einer Leiterplattenschicht für eine insbesondere mehrschichtige Leiterplatte, wobei eine Keramikfolie (2) mit darauf angeordneter Trägerfolie (3) verwendet wird, die Trägerfolie (3) zur Ausbildung mindestens einer Leiterbahn (17) durch Lasern gelocht und/oder die Tragerfolie (3) und die Keramikfolie (2) zur Ausbildung mindestens einer Durchkontaktierung (10) gemeinsam durch Lasern gelocht werden, anschließend durch Bedrucken die Leiterbahn (17) und/oder die Durchkontaktierung (10) erstellt werden, wobei die Trägerfolie (3) eine Druckschablone bildet, und anschließend die Trägerfolle (3) von der Keramikfolie (2) entfernt wird, **dadurch gekennzeichnet, dass** das Entfernen der Trägerfolie (3) mittels einem auf die Trägerfolie (3) aufgeklebten Klebsubstrat (20) insbesondere einer Klebefolie, (21) erfolgt, das gemeinsam mit der Trägerfolie (3) anschließend wieder abgezogen wird.

2. Verfahren nach einem der vorhergehenden Ansprüche, **dadurch gekennzeichnet, dass** die Leiterplattenschicht mindestens mit einer weiteren Leiterplattenschicht verbunden wird.

3. Verfahren nach einem der vorhergehenden Ansprüche, **dadurch gekennzeichnet, dass** die aus mehreren Leiterplattenschichten bestehende Leiterplatte gesintert wird.

4. Verfahren nach einem der vorhergehenden Ansprüche, **dadurch gekennzeichnet, dass** Durchkontaktierungen (10) von weniger als 80 µm Durchmesser, insbesondere von weniger als 75 µm Durchmesser, erstellt werden.

5. Verfahren nach einem der vorhergehenden Ansprüche, **dadurch gekennzeichnet, dass** Leiterbahne (17) mit einer Leiterbahnbreite von weniger als 130 µm, insbesondere von weniger als 100 µm, erstellt werden.

## Claims

1. Method for the production of a circuit board layer for a circuit board, particularly a multi-layer circuit board, a ceramic sheet (2) with a carrier film (3) arranged on it being used, the carrier film (3) being perforated by lasering to form at least one conductor track (17) and/or the carrier film (3) and the ceramic sheet (2) being jointly perforated by lasering to form at least one via hole (10), after which the conductor track (17) and/or the via hole (10) are created by printing, the carrier film (3) forming a printing stencil, and after which the carrier film (3) is removed from the ceramic sheet (2), **characterized in that** the removal of the carrier film (3) takes place by means of an adhesive substrate (20), in particular an adhesive film (21), which has been adhesively applied to the carrier film (3) and is subsequently pulled off again together with the carrier film (3).

2. Method according to one of the preceding claims, **characterized in that** the circuit board layer is connected at least to a further circuit board layer.

3. Method according to one of the preceding claims, **characterized in that** the circuit board consisting of multiple circuit board layers is sintered.

4. Method according to one of the preceding claims, **characterized in that** via holes (10) of less than 80 µm in diameter, in particular of less than 75 µm in diameter, are created.

5. Method according to one of the preceding claims, **characterized in that** conductor tracks (17) with a conductor track width of less than 130 µm, in particular of less than 100 µm, are created.

## Revendications

1. Procédé de fabrication d'une couche pour carte de circuit, notamment pour une carte de circuit multicouche,
le procédé utilisant un film (2) en céramique sur lequel est disposé un film de support (3),
le film de support (3) étant perforé par laser pour former au moins une piste conductrice (17) et/ou
le film de support (3) et le film en céramique (2) étant perforés conjointement par laser pour former au moins une perforation de contact (10),
la piste conductrice (17) et/ou la perforation de contact (10) étant ensuite formées par impression, le film de support (3) formant un gabarit d'impression, le film de support (3) étant ensuite enlevé du film en céramique (2),
**caractérisé en ce que**
l'enlèvement du film de support (3) s'effectue au moyen d'un substrat adhésif (20), en particulier un film adhésif (21), collé sur le film de support (3) et ensuite retiré en même temps que le film de support (3).

2. Procédé selon l'une des revendications précédentes, **caractérisé en ce que** la couche pour carte de circuit est reliée à au moins une autre couche pour carte de circuit.

3. Procédé selon l'une des revendications précédentes, **caractérisé en ce que** la carte de circuit constituée de plusieurs couches de carte de circuit est frittée.

4. Procédé selon l'une des revendications précédentes, **caractérisé en ce que** les perforations de contact (10) sont formées à un diamètre inférieur à 80 µm et en particulier à un diamètre inférieur à 75 µm.

5. Procédé selon l'une des revendications précédentes, **caractérisé en ce que** les pistes conductrices (17) sont formées à une largeur inférieure à 130 µm et en particulier inférieure à 100 µm.
